# FASCICULE DE BREVET EUROPEEN

(11) **EP 0 573 350 B1**
(45) Date de publication et mention de la délivrance du brevet: **25.09.1996**
(21) Numéro de dépôt: 93401402.8
(22) Date de dépôt: 02.06.1993
(51) Int. Cl.: H01F 5/00, G01R 15/00

(54) **Bobine de Rogowski**
Rogowskispule
Rogowski coil

(30) Priorité: 05.06.1992 FR 9206859
(43) Date de publication de la demande: 08.12.1993
(73) Titulaire: GEC ALSTHOM T ET D SA, 75016 Paris (FR)
(72) Inventeur: Gris, Jean-Paul, F-69005 Lyon (FR); Dupraz, Jean Pierre, F-69003 Lyon (FR)
(74) Mandataire: Fournier, Michel

(56) Documents cités:
- CH-A- 665 303
- DE-A- 3 712 190
- US-A- 5 055 816

## Description

La présente invention concerne une bobine de Rogowski.

On rappelle qu'une bobine de Rogowski, appelée parfois tore de Rogowski, se présente classiquement sous la forme d'un enroulement conducteur, bobiné sur un mandrin de forme torique constitué d'un matériau non ferromagnétique, ce qui lui confère d'excellentes caractéristiques de linéarité, dues à l'absence de saturation.

La bobine de Rogowski peut être utilisée notamment pour la mesure de l'intensité du courant à fréquence industrielle.

Pour cela, la bobine est chargée avec une résistance R, de valeur élevée.

La tension recueillie aux bornes de la bobine est une image de la dérivée du courant, sous réserve que R² soit très supérieure à r² + (L ω)², où r désigne la résistance ohmique de la bobine, L son inductance propre et ω la pulsation du courant à mesurer.

Il suffit alors d'intégrer cette tension pour avoir l'image du courant primaire.

Une des difficultés dans la mesure des courants au moyen d'une bobine de Rogowski de type classique résulte de la variation des paramètres de la bobine avec la température, qui entraîne des erreurs de mesure importantes.

Une autre difficulté provient du fait qu'il est difficile de réaliser une bobine de type classique ayant une parfaite symétrie axiale; or si la bobine n'est pas parfaitement symétrique , la mesure dépend de la position du conducteur traversant le tore et de son orientation.

Une symétrie axiale exige au minimum que l'enroulement soit constitué d'un double bobinage aller et retour; ceci est techniquement difficile, sinon impossible à réaliser en bobinant du fil autour d'un tore, et, en tous cas, le prix d'une bobine ainsi réalisée serait très élevé.

Un but de l'invention est de réaliser une bobine de Rogowski peu sensible aux variations de température.

Un autre but de l'invention est de réaliser une bobine ayant une symétrie axiale quasi parfaite.

Un autre but de l'invention est de réaliser une bobine de Rogowski de prix de revient relativement peu élevé.

Tous ces buts sonts atteints grâce à l'invention qui a pour objet une bobine de Rogowski comprennant au moins une plaque de circuit imprimé munie d'une découpe circulaire, le bobinage étant réalisé par des dépôts métalliques rectilignes sur chacune des deux faces de la plaque disposés selon des rayons dont le prolongement passe par le centre de ladite découpe, les liaisons électriques entre les rayons d'une face et ceux de la face opposée étant réalisés par des trous métallisés traversant l'épaisseur de la plaque.

Dans un mode préféré de réalisation, le bobinage constitué par les rayons et les trous comporte un aller et retour autour de la découpe circulaire avec une entrée et une sortie sur une même face de la plaque, séparés d'une distance de quelques dizièmes de millimètres.

Dans un mode particulier de réalisation, la bobine comporte une pluralité de plaques du type précité, disposées parallèlement entre elles et solidarisées entre elles, lesdites bobines étant mises en série par des liaisons électriques perpendiculaires aux plaques.

Dans un mode particulier de réalisation de la bobine à plusieurs plaques, les plaques sont carrées, les connexions d'entrée et de sortie des diverses plaques sont placées dans un angle du carré, les plaques portant chacune une découpe dans l'angle précité, la dimension de la découpe variant d'une plaque à la plaque adjacente.

Avantageusement, l'une des plaques porte le circuit électronique de traitement des signaux induits dans la bobine.

L'invention sera bien comprise à la lecture de la description ci-après d'un mode particulier de réalisation de l'invention, en référence au dessin annexé dans lequel:
- la figure 1 représente, vue en plan, une bobine de Rogowski selon l'invention,
- la figure 2 est un schéme expliquant la réalisation du bobinage de la bobine de l'invention,
- la figure 3 est une vue en perspective d'une bobine de Rogowski ayant deux plaques actives et une plaque à bornier.

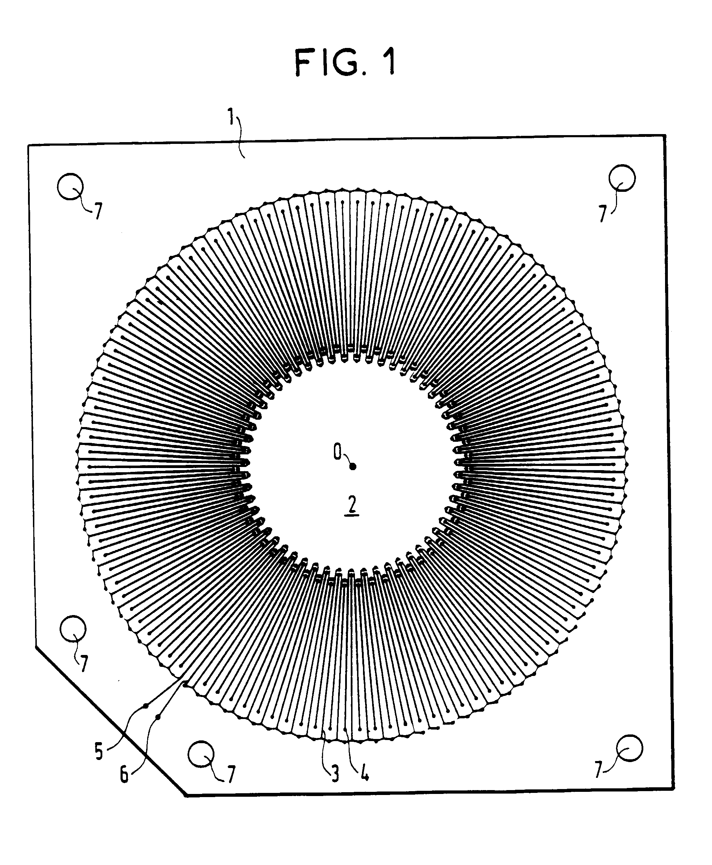

La figure 1 représente, vue en plan, une bobine de Rogowski selon l'invention.

Elle comprend une plaque de circuit imprimé double face, de préférence en résine époxy de préférence chargée de verre stratifié, à faible dilatation thermique. En variante, la plaque est réalisée en céramique ou tout matériau analogue, possédant un coefficient de dilatation très faible.

L'épaisseur de la plaque est avantageusement égale à 1,6mm.

La plaque, de préférence carrée, comporte un trou central 2 destiné à recevoir le câble dont on désire mesurer le courant.

Le bobinage est constitué par des dépôts de cuivre tel que 3, déposés sur chacune des faces de la plaque; ces dépôts sont rectilignes et radiaux, c'est à dire que leur prolongement passe par le centre 0 de la plaque; les dépôts d'une face sont reliés, comme il est décrit plus loin, aux dépôts de la face opposée, par des trous métallisés 4 traversant la plaque.

La surface du dépôt est stabilisée chimiquement par un dépôt d'or d'épaisseur contrôlée, afin de maîtriser la valeur de la résistance interne de la bobine de Rogowski.

L'homme du métier sait remplacer l'or par d'autres dépôts appropriés et protéger ces dépôts par des techniques adéquates, par exemple par des vernis épargnes.

On aperçoit, dans la figure 1, l'entrée 5 et la sortie 6 du bobinage, séparés de quelques dixièmes de mm, pour respecter la symétrie axiale du bobinage.

Les références 7 désignent des trous pour la fixation à la plaque d'autres plaques en vue de la constitution d'une bobine de Rogowski à plusieurs plaques.

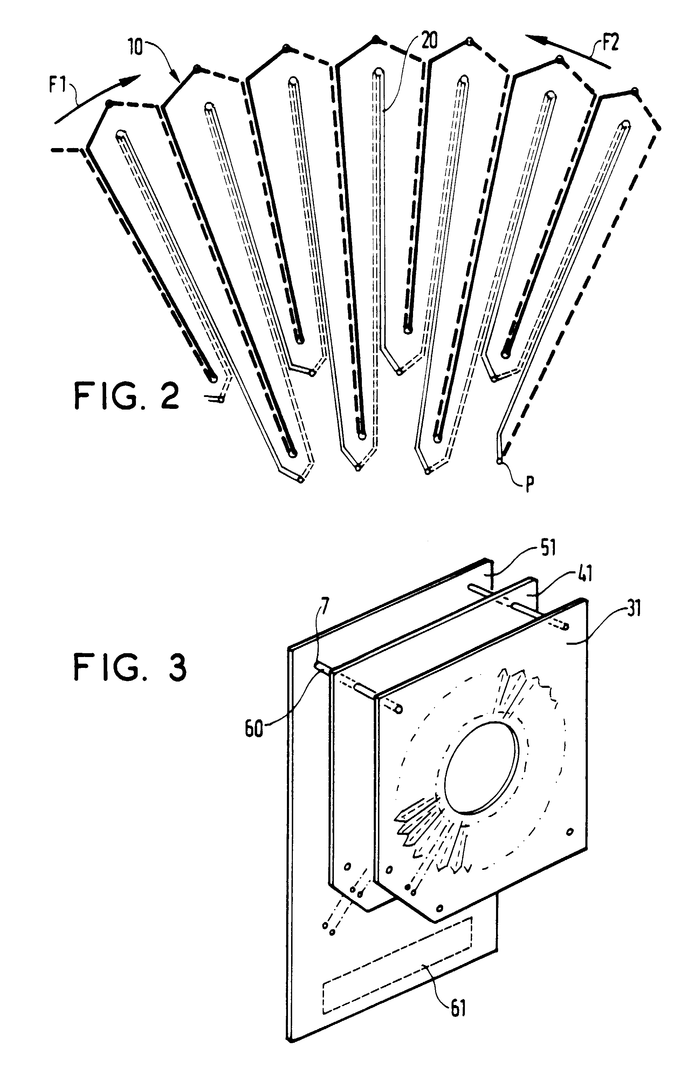

La figure 2 est un schéma expliquant la constitution du bobinage. Pour respecter une parfaite symétrie axiale, le bobinage est constitué de deux enroulements en série, l'un 10, dit premier enroulement, bobiné dans le sens des aiguilles d'une montre, l'autre 20, dit second enroulement, bobiné dans le sens inverse des aiguilles d'une montre. La figure 2 montre schématiquement, vue en plan, une partie de ce bobinage et on a adopté les conventions suivantes: le premier enroulement 10 est représenté en trait épais continu lorsque le dépôt est sur la face visible de la plaque et en trait épais interrompu lorsque le dépôt est sur la face opposée; le second enroulement 20 est représenté en double trait continu ou interrompu selon que le dépôt est sur la face visible ou la face opposée. Pour la compréhension du dessin, on a représenté côte-à-côte les deux rayons correspondant à une même spire, mais on doit bien comprendre que ces deux rayons sont exactement situés l'un en face de l'autre sur les deux faces de la plaque. La flèche F1 donne le sens d'enroulement du premier enroulement, la flèche F2 le sens d'enroulement de l'autre enroulement. Le point P est le point où les enroulements 10 et 20 sont mis en série.

Une plaque de la dimension de celle de la figure 1 peut comporter de l'ordre de 250 spires; il est possible d'accroître la sensibilité de la bobine en utilisant plusieurs plaques du type de celle de la figure 1. La figure 3 montre une bobine comprenant trois plaques bobinées, 31, 41 et 51, disposées parallèlement entre elles, et maintenues solidaires par des tirants 60 passant par les trous 7; les plaques 31 et 41 portent des découpes triangulaires de dimensions inégales, pour faciliter les connexions des bobines, réalisés à l'aide de conducteurs non représentés traversant les plaques perpendiculairement à leur plan.

La plaque 51, qui ne porte pas de découpe, est, dans l'exemple de la figure 3, rectangulaire, et porte le circuit électronique de traitement des signaux induits dans la bobine de Rogowski, ce circuit étant symbolisé par le rectangle 61. De la sorte, les connexions sont très courtes et n'induisent pas de signaux perturbateurs.
On notera que les connexions de sortie sont réalisées à l'aide de pistes (dépôts métalliques) situées d'un même côté de la plaque, de manière à minimiser l'influence du champ magnétique créé par le courant à mesurer.

L'invention est de mise en oeuvre économique; elle permet une grande précision de mesure, car, grâce à l'emploi de résine époxy, la variation de résistance de la bobine avec la température est très faible, de l'ordre de 80 millionième par degré.

Cette circonstance permet d'ailleurs de contrôler la qualité du dépôt par une simple mesure de la résistance du bobinage.

## Revendications

1. Bobine de Rogowski comprennant au moins une plaque de circuit imprimé (1) munie d'une découpe circulaire (2), le bobinage étant réalisé par des dépôts métalliques rectilignes (3) sur chacune des deux faces de la plaque disposés selon des rayons dont le prolongement passe par le centre de ladite découpe, les liaisons électriques entre les rayons d'une face et ceux de la face opposée étant réalisés par des trous métallisés (4) traversant l'épaisseur de la plaque.

2. Bobine de Rogowski selon la revendication 1, caractérisé en ce que le bobinage constitué par les rayons et les trous comporte un aller (10) et retour (20) autour de la découpe circulaire (2) avec une entrée (5) et une sortie (6) sur une même face de la plaque, séparés d'une distance de quelques dizièmes de millimètres.

3. Bobine de Rogowski selon l'une des revendications 1 et 2, caractérisée en ce qu'elle comporte une pluralité de plaques (31, 41, 51), disposées parallèlement entre elles et solidarisées entre elles, lesdites bobines étant mises en série par des liaisons électriques perpendiculaires aux plaques.

4. Bobine de Rogowski selon la revendication 3, caractérisée en ce que les plaques (31, 41) sont carrées, les connexions d'entrée et de sortie des diverses plaques sont placées dans un angle du carré, d'un même côté de la plaque correspondante, les plaques comportant chacune une découpe dans l'angle précité, la dimension de la découpe variant d'une plaque à la plaque adjacente.

5. Bobine de Rogowski selon l'une des revendications 3 et 4, caractérisée en ce que l'une (51) des plaques porte le circuit électronique (61) de traitement des signaux induits dans la bobine.

6. Bobine de Rogowski selon l'une des revendications 1 à 5, caractérisé en ce que le matériau de la carte est de la résine époxy.

7. Bobine de Rogowski selon la revendication 6, caractérisée en ce que la résine est chargée de verre stratifié.

8. Bobine de Rogowski selon l'une des revendications 1 à 5, caractérisée en ce que le matériau de la carte est un matériau à très faible coefficient de dilatation, tel que la céramique.

9. Bobine de Rogowski selon l'une des revendications 1 à 8, caractérisée en ce que le dépôt métallique est stabilisé chimiquement, par exemple par un dépôt métallique tel qu'un dépôt d'or.

10. Bobine de Rogowski selon l'une des revendications 1 à 9, caractérisée en ce que le circuit imprimé reçoit un traitement de protection, par exemple un vernis épargne.

## Patentansprüche

1. Rogowski-Spule, die mindestens eine Druckschaltungsplatte (1) mit einem kreisförmigen Ausschnitt (2) besitzt, wobei die Spule durch Aufbringen geradliniger Metallbahnen (3) auf die beiden Seiten der Platte gebildet wird und die Bahnen derart radial verlaufen, daß ihre Verlängerung durch den Mittelpunkt des Ausschnitts verläuft, und wobei die elektrischen Verbindungen zwischen den radial verlaufenden Bahnen einer Seite und denen der anderen Seite über metallbeschichtete Löcher (4) erfolgt, die die Platte durchdringen.

2. Rogowski-Spule nach Anspruch 1, dadurch gekennzeichnet, daß die aus den radial verlaufenden Bahnen und den Löchern gebildete Spule eine Wicklung (10) in einer Richtung um den kreisförmigen Ausschnitt (2) herum und eine Wicklung (20) in der anderen Richtung um den kreisförmigen Ausschnitt (2) herum enthält, wobei ein Eingang (5) und ein Ausgang (6) auf einer gemeinsamen Seite der Platte liegen und einen gegenseitigen Abstand von einigen zehntel Millimetern besitzen.

3. Rogowski-Spule nach einem der Ansprüche 1 und 2, dadurch gekennzeichnet, daß sie mehrere Platten (31, 41, 51) in zueinander paralleler, fester Anordnung besitzt, wobei die Spulen über elektrische Verbindungen senkrecht zu den Platten in Reihe geschaltet sind.

4. Rogowski-Spule nach Anspruch 3, dadurch gekennzeichnet, daß die Platten (31, 41) quadratisch sind, wobei der Eingang und der Ausgang der verschiedenen Platten in einem Eck des Quadrats auf einer gleichen Seite der entsprechenden Platte liegen und das erwähnte Eck der Platten so abgeschnitten ist, daß die Abmessungen von einer Platte zur nächsten variieren.

5. Rogowski-Spule nach einem der Ansprüche 3 und 4, dadurch gekennzeichnet, daß eine der Platten (51) die elektronische Schaltung (61) zur Verarbeitung der in der Spule induzierten Signale trägt.

6. Rogowski-Spule nach einem der Ansprüche 1 bis 5, dadurch gekennzeichnet, daß das Material der Karte Epoxyharz ist.

7. Rogowski-Spule nach Anspruch 6, dadurch gekennzeichnet, daß das Harz eine Glasmatte enthält.

8. Rogowski-Spule nach einem der Ansprüche 1 bis 5, dadurch gekennzeichnet, daß das Material der Karte einen sehr geringen Ausdehnungskoeffizienten hat, wie z.B. eine Keramik.

9. Rogowski-Spule nach einem der Ansprüche 1 bis 8, dadurch gekennzeichnet, daß die Metallbeschichtung chemisch stabilisiert ist, beispielsweise durch eine Metallschicht wie z.B. Gold.

10. Rogowski-Spule nach einem der Ansprüche 1 bis 9, dadurch gekennzeichnet, daß die Druckschaltung eine Schutzbehandlung erfährt, beispielsweise aus einem Deckharz.

## Claims

1. A Rogowski coil comprising at least one printed circuit plate (1) provided with a circular cutout (2), the coil being implemented by rectilinear metal deposits (3) on each of the two faces of the plate and extending along radii such that geometrical projections thereof intersect in the center of said cutout, electrical connections between the radii on one face and those on the opposite face being implemented by plated through holes (4) that pass through the thickness of the plate.

2. A Rogowski coil according to claim 1, characterized in that the coil is constituted by the radially-extending portions and by the holes, including a go path (10) and a return path (20) disposed around the circular cutout (2), with an inlet (5) and an outlet (6) on the same face of the plate, said inlet and outlet being separated by a distance of a few tenths of a millimeter.

3. A Rogowski coil according to claim 1 or 2, characterized in that it includes a plurality of plates (31, 41, 51), disposed parallel to one another and secured together, said coils being connected in series by electrical connections perpendicular to the plates.

4. A Rogowski coil according to claim 3, characterized in that the plates (31, 41) are square, the inlet and outlet connections between the various plates being connected in one of the corners of the square, of the same side of the corresponding plate, each of the plates including a cutout in the above-mentioned corner, with the side of the cutout varying from one plate to the adjacent plate.

5. A Rogowski coil according to claim 3 or 4, characterized in that one (51) of the plates caries an electronic circuit (61) for processing the signals induced in the coil.

6. A Rogowski coil according to any one of claims 1 to 5, characterized in that the material of the plate is epoxy resin.

7. A Rogowski coil according to claim 6, characterized in that the resin is filled with stratified glass.

8. A Rogowski coil according to any one of claims 1 to 5, characterized in that the plate material is a material having a very low coefficient of thermal expansion, such as a ceramic.

9. A Rogowski coil according to any one of claims 1 to 8, characterized in that the metal deposit is chemically stabilized, e.g. by a metal deposit such as a deposit of gold.

10. A Rogowski coil according to any one of claims 1 to 9, characterized in that the printed circuit receives protective treatment, e.g. by means of a protective varnish.
